# EUROPEAN PATENT SPECIFICATION

(11) **EP 1 353 441 B1**
(45) Date of publication and mention of the grant of the patent: **05.10.2005**
(21) Application number: 02729520.3
(22) Date of filing: 09.01.2002
(51) Int. Cl.: H03H 9/145, H03H 3/08

(54) **SAW DEVICE AND PRODUCTION METHOD THEREFOR**
SAW-BAUELEMENT UND VERFAHREN ZU SEINER HERSTELLUNG
DISPOSITIF SAW ET PROCEDE DE PRODUCTION DE CE DISPOSITIF

(30) Priority: 15.01.2001 JP 2001006031
(43) Date of publication of application: 15.10.2003
(73) Proprietor: MATSUSHITA ELECTRIC INDUSTRIAL CO., LTD., Kadoma-shi, Osaka 571-8501 (JP)
(72) Inventor: MATSUO, Satoshi, Hirakata-shi, Osaka 573-0083 (JP); INOUE, Takashi, Suita-shi, Osaka 565-0852 (JP); MURAKAMI, Yoshiki, Sakai-shi, Osaka 590-0134 (JP)
(74) Representative: Grünecker, Kinkeldey, Stockmair & Schwanhäusser Anwaltssozietät
(86) International application number: PCT/JP2002/000032
(87) International publication number: WO 2002/056465

(56) References cited:
- DE-A- 2 749 294
- JP-A- 2000 261 283
- JP-A- 2002 033 633
- JP-A- 2002 064 352
- PATENT ABSTRACTS OF JAPAN vol. 1998, no. 11, 30 September 1998 (1998-09-30) -& JP 10 163800 A (SANYO ELECTRIC CO LTD), 19 June 1998 (1998-06-19)
- PATENT ABSTRACTS OF JAPAN vol. 011, no. 190 (E-517), 18 June 1987 (1987-06-18) -& JP 62 020351 A (NEC CORP), 28 January 1987 (1987-01-28)
- PATENT ABSTRACTS OF JAPAN vol. 1997, no. 11, 28 November 1997 (1997-11-28) -& JP 09 199967 A (NEC CORP), 31 July 1997 (1997-07-31)

## Description

### TECHNICAL FIELD

The present invention relates to surface acoustic wave (SAW) devices used to wireless equipment, such as wireless communications equipment, and a method of manufacturing the devices.

### BACKGROUND ART

A conventional surface acoustic wave (SAW) device featuring moisture-resistance is disclosed in Japanese Patent Laid-Open No.2000-261283.

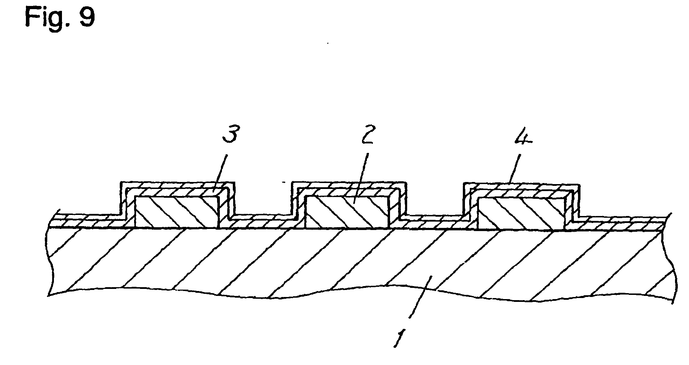

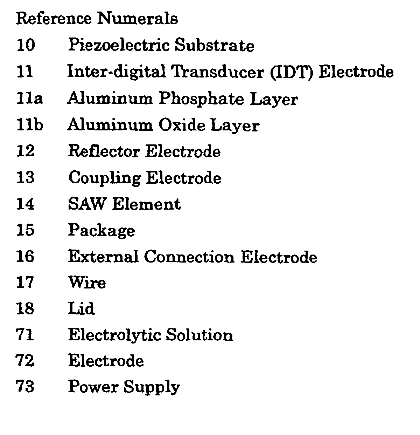

Fig. 9 is an enlarged cross-sectional view of the conventional SAW device. The SAW device includes piezoelectric substrate 1 composed of lithium tantalate single crystal, inter-digital transducer (IDT) electrode 2 composed mainly of aluminum formed on the piezoelectric substrate, insulating protective layer 3 composed of SiO₂ and the like for covering a surface of piezoelectric substrate 1 and IDT electrode 2, and water-repellent protective layer 4 composed of water-repellent material, such as hexamethyl disilane and the like covering insulating protective layer 3.

A method of manufactrung the SAW device will be described. First, IDT electrodes 2 are formed on piezoelectric substrate 1 by photolithography. Next, a spattering apparatus forms insulating protective layer of SiO₂ and the like on IDT electrodes 2. Finally, water-repellent protective layer 4 of hexamethyl disilane is applied on insulating protective layer 3.

As shown in Fig. 9, insulating protective layer 3 and water-repellent protective layer 4 of the conventional SAW devices cover surfaces of piezoelectric substrate 1 between fingers of IDT electrode 2. The insulating protective layer 3 and water-repellent protective layer 4 between the fingers attenuate surface acoustic waves propagated between IDT electrode fingers on piezoelectric substrate 1, though providing the SAW device with moisture-resistance. Consequently, the SAW device, upon being used as a filter, has deteriorating electrical property due to, for example, increase of its insertion loss.

German Patent Application DE-A-2749294 discloses a method for manufacturing a semicondutor element wherein aluminium wiring is protected by a thin aluminium phosphate film formed by treating the metal surface with a solution containing phosphorous ions.

### SUMMARY OF THE INVENTION

A surface acoustic wave (SAW) device having a high moisture-resistance and electrical property prevented from deterioration. The SAW device includes a piezoelectric substrate, an electrode containing aluminum on the piezoelectric substrate, and an aluminum phosphate layer applied only on the electrode.

### BRIEF DESCRIPTION OF THE DRAWINGS

Fig. 1 is an enlarged cross-sectional view of an essential portion of a surface acoustic wave (SAW) element according to exemplary embodiment 1 of the present invention.
Fig. 2 is a plan view of a SAW element according to exemplary embodiments 1 and 2 of the invention.
Fig. 3 is a cross-sectional view of a SAW device according to embodiments 1 and 2.
Fig. 4 is a diagram of a manufacturing process of a SAW device according to embodiments 1 and 2.
Fig. 5 is a variation for a time of a center frequency in a moisture test for SAW devices according to embodiments 1 and 2 and a SAW device of a comparative example.
Fig. 6 is an enlarged cross-sectional view of a SAW device according to embodiment 2.
Fig. 7 is a diagram of a manufacturing process of a SAW device according to embodiment 2.
Fig. 8 is a schematic view of an anode oxidization process of a SAW device according to embodiment 2.
Fig. 9 is an enlarged cross-sectional view of an essential portion of a conventional SAW element.

### DETAILED DESCRIPTION OF THE PREFERRED EMBODIMENTS

### (Exemplary Embodiment 1)

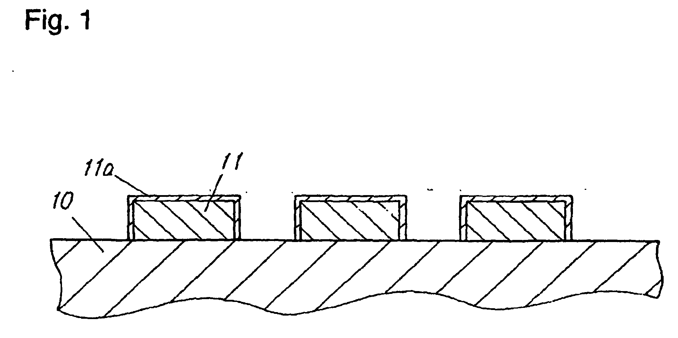

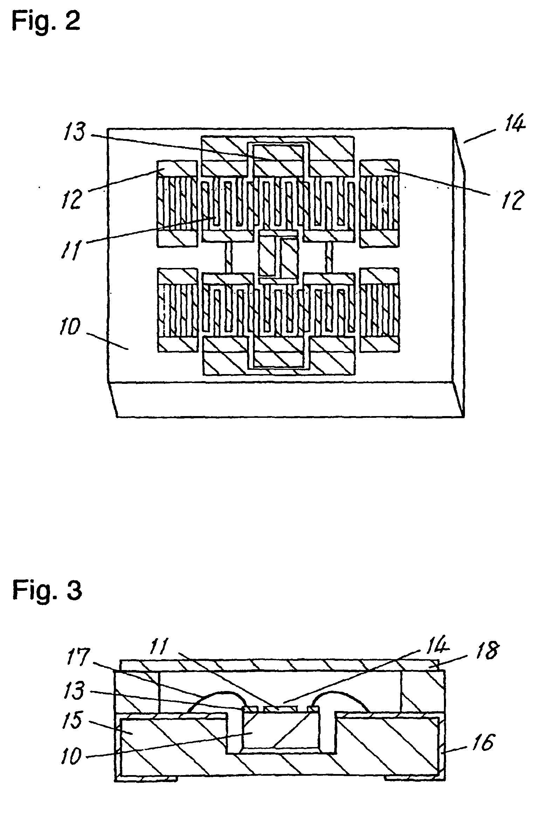

Fig. 1 is an enlarged cross-sectional view of an essential portion of a surface acoustic wave (SAW) element according to exemplary embodiment 1, Fig. 2 is a plan view of the SAW element, and Fig. 3 is a cross-sectional view of a SAW device.

The SAW element shown in Figs. 1 through 3 includes piezoelectric substrate 10 composed of lithium tantalate single crystal or lithium niobate single crystal, inter-digital transducer (IDT) electrode 11 formed on piezoelectric substrate 10, aluminum phosphate layer 11a covering a surface of IDT electrode 11, reflector electrodes 12 at both sides of IDT electrode 11 on piezoelectric substrate 10, and connection electrode 13 formed on piezoelectric substrate 10 for being electrically-connected to IDT electrode 11. The SAW device includes package 15 for accommodating SAW element 14, external connection electrode 16 provided on package 15, wire 17 for connecting connection electrode 13 to external connection electrode 16, and lid 18 to close an opening of package 15. IDT electrode 11, reflector electrode 12, and connection electrode 13 are made of metal mainly composed of aluminum.

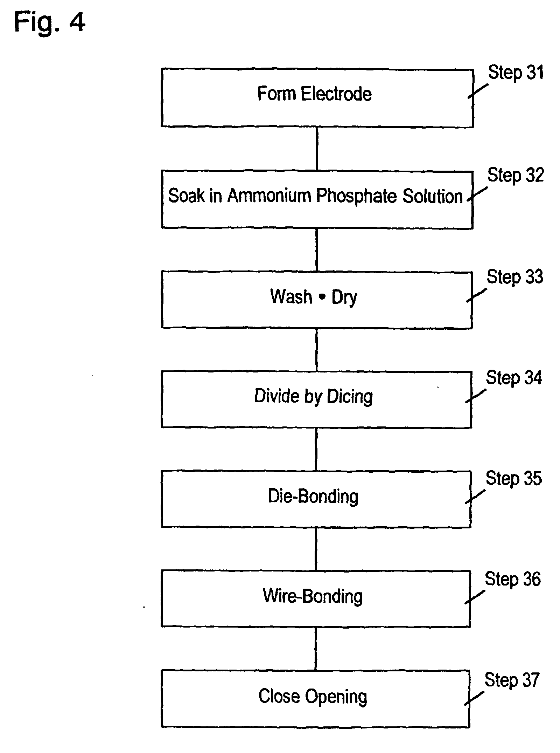

A method of manufacturing the SAW device will described with reference to drawings. Fig. 4 is a diagram of a manufacturing process of the SAW device according to embodiment 1.

First, plural IDT electrodes 11, reflector electrodes 12, and connection electrodes 13 made of metal mainly composed of aluminum are formed on plate-shaped piezoelectric substrate 10 by photolithography (step 31).

Then, piezoelectric substrate 10 is soaked in 0.5 to 60% ammonium phosphate solution of pH 3 to 5 for a predetermined time (step 32). The ammonium phosphate solution is adopted because of its controllablity in pH, however, any solution that produces aluminum phosphate in reaction with aluminum may be alternative. Concentration of not more than 0.5% solution forms layer less efficiently, but electrode material, aluminum, dissolves easily in concentration of not less than 60% solution. Piezoelectric substrate 10 is preferably soaked not more than 30 minutes. A shorter time, approx. 1 second, is permissible, but a time longer than 30 minutes is not preferable because the electrode material, aluminum, dissolves in the solution.

The piezoelectric substrate is washed in water and dried after being taken out of the solution (step 33). A wafer for example, may be rinsed with pure water and is then rotated to blow the water (rinse-drying). Here, rotating the wafer to blow the water is effective to prevent the wafer from spots on the wafer.

Then, SAW element 14 on piezoelectric substrate is measured in frequency characteristics and is sorted. Subsequently, as shown in Fig. 2, piezoelectric substrate 10 is divided by dicing into each SAW element 14 including IDT electrode 11, reflector electrodes 12 formed on both sides of IDT electrode 11, and connection electrode 13 electrically-connected to IDT electrode 11 (step 34). As shown in Fig. 1, a surface of IDT electrode 11 of SAW element 14 is covered with thin aluminum phosphate layer 11a. Surfaces of reflector electrode 12 and connection electrode 13 are covered with aluminum phosphate layer 11a as well. Aluminum phosphate layer 11a is formed to have a thickness to make IDT electrode 11 have almost identical electrical properties before and after the layer is formed.

Then, SAW element 14 is mounted in package 15 (step 35). Then, connection electrode 13 of SAW element 14 and external connection electrode 16 on package 15 are connected with wire 17 (step 36). Then, lid 18 closes an opening of package 15 (step 37), and thus, SAW device shown in Fig. 3 is provided.

Properties of the SAW device according to this embodiment will be described.

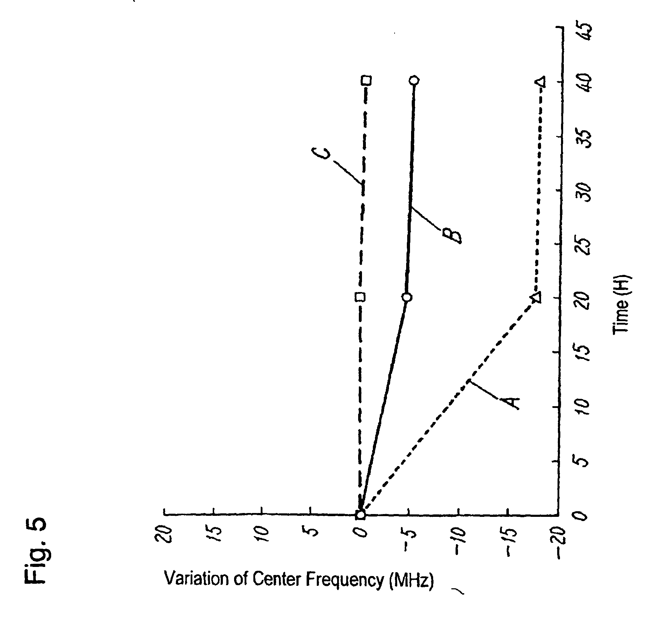

Fig. 5 shows variations of a center frequency of each of the SAW device according to embodiment 1 and a SAW device having no aluminum phosphate layer on the IDT electrode (a comparative example) after a certain time under an atmosphere of 2.03×10⁵Pa and 100% humidity. Each SAW device operates as a SAW filter having a center frequency of 2.14GHz.

As shown in Fig. 5, the center frequency (curve A) varies by approximately 18% after the certain time in the SAW device having no aluminum phosphate layer (curve A). The center frequency (curve B) varies by only approximately 5% after 40 hours in the SAW device according to embodiment 1 having high moisture-resistance.

The SAW device according to embodiment 1 has aluminum phosphate layer 11a only on the surface of IDT electrode 11. This prevents surface acoustic waves in the SAW device for attenuation, and reduces insertion loss of the device more than conventional SAW devices having protective layers also on a surface of a piezoelectric substrate.

Moreover, the moisture-resistant aluminum phosphate layer 11a is formed only on the surface of IDT electrode 11 by soaking piezoelectric substrate 10 having IDT electrode 11 into the ammonium phosphate solution. This construction prevents IDT electrode 11 composed of aluminum from chemically-changing into aluminum hydroxide, and prevents the SAW device from depreciation in electrical property. Chemical reactions in which the aluminum change into the aluminum hydroxide may occur, for example, near boundary between the piezoelectric substrate and aluminum phosphate layer 11a. The aluminum hydroxide chemically-changed from the aluminum dissolves in water easily, and the dissolving aluminum hydroxide changes weights of the electrodes and changes or fluctuates propagation property of the surface acoustic waves on the piezoelectric substrate. Additionally, since the aluminum hydroxide has a resistance almost identical to that of an insulator, the electrodes has their increased resistances, and thus causing larger propagation loss of the waves.

Since aluminum phosphate layer 11a is formed to have its thickness to make IDT electrode 11 to have almost identical electrical properties before and after the layer is formed, a SAW filter having desired electrical properties is provided. A thickness of the layer, not being measured correctly due to out of precision limit of ordinary measurement equipment, is order of 0.1nm. Therefore, the aluminum phosphate layer does not affect a total thickness of IDT electrode 11. A time for soaking piezoelectric substrate 10 in the solution controls the thickness of the aluminum phosphate layer. The layer is formed for a short period of time, and after that, the thickness saturates. Shortest time for soaking provides the layer with an approximately-desired thickness.

The ammonium phosphate solution of pH 3 to 5 suppresses that aluminum, main component material of IDT electrode 11, reflector electrode 12, and connection electrode 13, dissolves easily in it, and thus prevents the properties of the SAW device form deterioration. Dissolution rate of aluminum depends on pH value, and aluminum hardly dissolves in pH 3 to 5 solution.

### (Exemplary Embodiment 2)

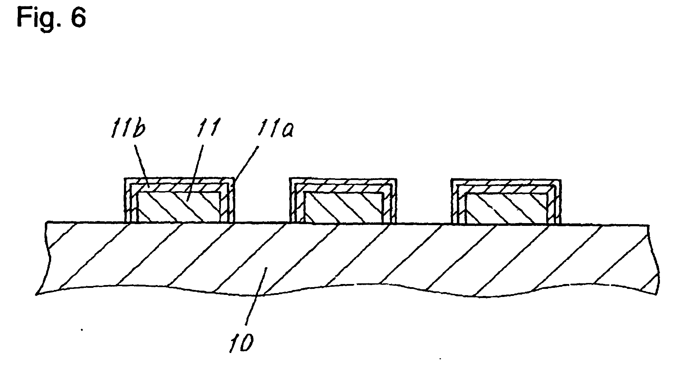

Fig. 2 is a plan view of a surface acoustic wave (SAW) element according to exemplary embodiment 2. Fig. 3 is an enlarged cross-sectional view of an essential portion of a SAW device. Fig. 6 is an enlarged cross-sectional view of an essential portion of the SAW element. Similar configuration elements described in embodiment 1 are denoted by the same reference numerals, and the descriptions thereof are omitted. In the figure, aluminum phosphate layer 11a covers over aluminum oxide layer 11b applied only on a surface of an inter-digital transducer (IDT) electrode for shielding the surface of the IDT electrode.

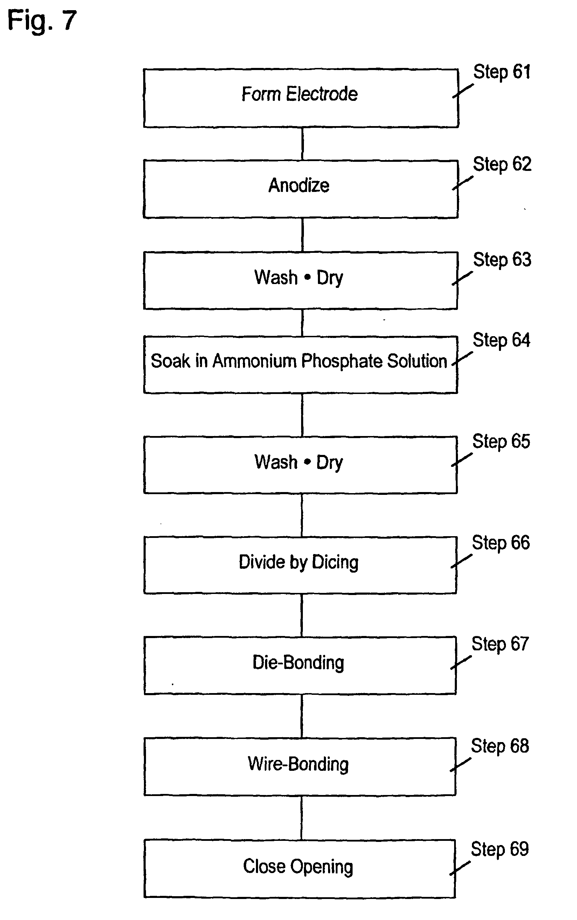

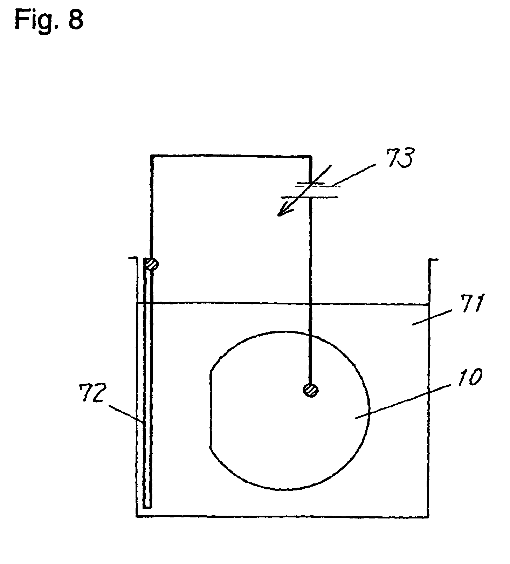

A method of manufacturing the SAW device is described. Fig. 7 is a diagram of a manufacturing process of the SAW device used according to embodiment 2. Fig. 8 is a schematic view of an anode oxidization process of the SAW device. A manufacturing apparatus is provided with electrolytic solution 71, electrode 72 and power supply73. Similar elements described in embodiment 1 are denoted by the same reference numerals, and the descriptions thereof are omitted.

First, similarly to embodiment 1, plural IDT electrodes 11, reflector electrodes 12, and connection electrodes 13 made of metal mainly composed of aluminum are formed on plate-shaped piezoelectric substrate 10 by photolithography (step 61).

Then, as shown in Fig. 8, piezoelectric substrate 10 is soaked in electrolytic solution 71 together with electrode 72 made of, for example, stainless steel. Power supply 73 applies a voltage between electrode 72 as a cathode and IDT electrode 11 as an anode. The voltage anodizes a surface of IDT electrode 11, which is thus covered with an aluminum oxide layer (step 62). The voltage applied for anodizing controls the thickness of the layer aluminum oxide. For example, a voltage of 3 to 50V forms the aluminum oxide layer of 4 to 70nm thickness. An IDT electrode of any construction on a wafer can be formed by anodizing if a voltage is applied to the electrode.

After being taken out of electrolytic solution 71, piezoelectric substrate 10 is washed in pure water and is dried (step 63). Then, piezoelectric substrate 10 is soaked in 0.5 to 60 % ammonium phosphate solution of pH 3 to 5 for a predetermined time (step 64), and then, is washed in water and dried after being taken out of the ammonium phosphate solution (step 65). An ammonium phosphate solution identical to that of embodiment 1 is used.

Subsequently, as shown in the figure, piezoelectric substrate 10 is divided by dicing into each SAW element 14 having IDT electrode 11, reflector electrode 12 at both sides of IDT electrode 11, and connection electrode 13 electrically connected to IDT electrode 11 (step 66).

As shown in Fig. 6, in SAW element 14, ICT electrode 11 is covered with aluminum oxide layer 11b and aluminum phosphate layer 11a on the layer 11b. Similarly to IDT element 11, aluminum phosphate layer 11a covers aluminum oxide layer 11b covering surfaces of reflector electrodes 12 and connection electrodes 13. A portion which is not anodized is covered only with aluminum phosphate layer 11a. The thickness of the aluminum oxide layer is 4 to 70nm, and the thickness of the aluminum phosphate layer is order of 0.1nm.

Then, SAW element 14 is bonded to package 15 by die bonding (step 67). Then, connection electrode 13 of SAW element 14 and external connection electrode 16 on package 15 are connected with wire 17 (step 68).

Then, lid 18 closes an opening of package 15 (step 69), thus providing the SAW device shown in the figure.

Properties of the SAW device according to embodiment 2 will be described.

Fig. 5 shows a variation of a center frequency of each SAW device according to embodiment 2 and a SAW device having no aluminum phosphate layer on the IDT surface after a certain time in an atmosphere of 2.03×10⁵Pa and 100% humidity. Each SAW device operates as a SAW filter having a center frequency of 2.14GHz.

As shown in Fig. 5, the center frequency (curve A) varies by approximately 18% after the certain time in the SAW device having no aluminum phosphate layer. This is because aluminum, a main component material of IDT electrode 11, chemically changes to aluminum hydroxide, and increases a weight of IDT electrode 11 due to moisture around SAW element 14.

The center frequency (curve C) varies little after 40hours in the SAW device according to embodiment 2. In the SAW device, aluminum phosphate layer 11a on IDT electrode 11, being water-repellent, prevents water from permeation, and thus prevents aluminum from chemical change.

Moreover, aluminum oxide layer 11b formed between aluminum phosphate layer 11a and IDT electrode 11 prevents water from permeation. The SAW device having aluminum oxide layer 11b additionally has a higher moisture-resistant properties than SAW device having only aluminum phosphate layer over the IDT electrode.

The voltage applied for anodizing controls the thickness of aluminum oxide layer 11b, but a time for applying influences the thickness little.

Aluminum phosphate layer 11a formed on IDT electrode 11 increases whole weight of IDT electrode 11. Therefore, the thickness of aluminum phosphate layer 11a is preferably limited to a minimum value effective to prevent IDT electrode 11 from chemical change. In the embodiments, the thickness is out of precision limit of ordinary measurement equipment, but supposedly is order of 0.1nm.

Additionally, increase of IDT elecrode11 makes a passing frequency band shift toward lower frequency. Therefore, the passing frequency band of IDT electrode 11 is preferably set higher initially by a certain value than a design target frequency to compensate the frequency variation due to aluminum phosphate layer 11a. The frequency f is determined by a formula f = v/λ, where v is a sound velocity in piezoelectric substrate, and λ is a wavelength determined by a finger pitch of the IDT electrode.

According to the embodiments, the ammonium phosphate solution is used as a phosphate solution. Any acidic solution including phosphorous-ion, preferably of pH 3 to 5, can form aluminum phosphate layer 11a efficiently without damaging the IDT electrode.

Aluminum phosphate layer being water-repellent formed on the IDT electrode prevents water form permeation, and thus, prevents aluminum from chemical change. Any material, other than aluminum phosphate, capable of forming a water-repellent protective layer exhibits the same effects. More specifically, other phosphates capable of forming a water-repellent protective layer can be used.

### INDUSTRIAL APPLICABILITY

A SAW device according to the invention includes an aluminum phosphate layer covering only over an IDT electrode. Aluminum phosphate layer is not formed on surfaces of piezoelectric substrate between fingers of the IDT electrode. The SAW device is moisture-resistant and does not deteriorate in electrical properties.

## Claims

1. A surface acoustic wave, [SAW], device (14) comprising:
a piezoelectric substrate (10);
an electrode (11)(12)(13) containing aluminum on said piezoelectric substrate (10); and
an aluminum phosphate layer (11a) covering only over said electrode (11)(12)(13).

2. The SAW device of claim 1, further comprising:
an aluminum oxide layer (11b) over said electrode (11)(12)(13).

3. The SAW device of claim 1, wherein said electrode (11)(12)(13) includes an inter-digital transducer, [IDT], electrode (11) (13).

4. The SAW device of claim 3, wherein said electrode (11)(12)(13) further includes a reflector electrode (12) disposed around said IDT electrode (11) (13).

5. A method for manufacturing a surface acoustic wave [SAW], device, comprising the steps of:
forming an electrode containing aluminum on a piezoelectric substrate; and
forming an aluminum phosphate layer over the electrode through soaking the piezoelectric substrate in solution containing phosphorous-ion.

6. The method of claim 5, wherein said step of forming the aluminum phosphate layer comprises the sub-step of having the aluminum phosphate layer have a thickness for making the electrode have an identical electrical property before and after the aluminum phosphate layer is formed.

7. The method of claim 5, wherein the solution has an acidity of pH 3 to 5.

8. The method of claim 5, further comprising the step of:
forming an aluminum oxide layer over the electrode by anodizing.

## Patentansprüche

1. Oberflächenwellen[OFW]-Bauelement (14) umfassend:
ein piezoelektrisches Substrat (10);
eine Elektrode (11)(12)(13), die Aluminium enthält, auf dem piezoelektrischen Substrat (10); und
eine Aluminiumphosphat-Schicht (11a), die nur die Elektrode (11)(12)(13) bedeckt.

2. OFW-Bauelement nach Anspruch 1, weiterhin umfassend:
eine Aluminiumoxid-Schicht (11b) über der Elektrode (11)(12)(13).

3. OFW-Bauelement nach Anspruch 1, wobei die Elektrode (11)(12)(13) eine Interdigitalwandler[IDT]-Elektrode (11)(13) enthält.

4. OFW-Bauelement nach Anspruch 3, wobei die Elektrode (11)(12)(13) weiterhin eine Reflektor-Elektrode (12) enthält, die um die ITD-Elektrode (11)(13) herum angeordnet ist.

5. Verfahren zur Herstellung eines Oberflächenwellen[OFW]-Baulementes, mit den Schritten:
Ausbildung einer Elektrode, die Aluminium enthält, auf einem piezoelektrischen Substrat und
Ausbildung einer Aluminiumphosphat-Schicht über der Elektrode durch Tränken des piezoelektrischen Substrates in einer Lösung, die Phosphorionen enthält.

6. Verfahren nach Anspruch 5, wobei der Schritt zur Ausbildung der Aluminiumphosphat-Schicht einen Teilschritt zum Beeinflussen der Dicke der Aluminiumphosphat-Schicht umfaßt, damit die Elektrode vor und nach Ausbildung der Aluminiumphosphat-Schicht identische elektrische Eigenschaften hat.

7. Verfahren nach Anspruch 5, wobei die Lösung einen Säuregehalt mit einem pH-Wert von 3 bis 5 aufweist.

8. Verfahren nach Anspruch 5, weiterhin umfassend den Schritt:
Ausbildung einer Aluminiumoxid-Schicht über der Elektrode durch Eloxieren.

## Revendications

1. Dispositif à ondes acoustiques de surface [SAW] (14), comprenant :
un substrat piézoélectrique (10) ;
une électrode (11) (12) (13) contenant de l'aluminium sur ledit substrat piézoélectrique (10) ; et
une couche de phosphate d'aluminium (11a) recouvrant uniquement ladite électrode (11) (12) (13).

2. Dispositif SAW selon la revendication 1, comprenant en outre :
une couche d'oxyde d'aluminium (11b) par-dessus ladite électrode (11) (12) (13).

3. Dispositif SAW selon la revendication 1, dans lequel ladite électrode (11) (12) (13) inclut une électrode de transducteur interdigité [IDT] (11) (13).

4. Dispositif SAW selon la revendication 3, dans lequel ladite électrode (11) (12) (13) inclut en outre une électrode de réflecteur (12) placée autour de l'électrode IDT (11) (13).

5. Procédé de fabrication d'un dispositif à ondes acoustiques de surface [SAW], comprenant les étapes consistant à :
former une électrode contenant de l'aluminium sur un substrat piézoélectrique ; et
former une couche de phosphate d'aluminium par-dessus l'électrode par trempage du substrat piézoélectrique dans une solution contenant des ions phosphore.

6. Procédé selon la revendication 5, dans lequel ladite étape consistant à former la couche de phosphate d'aluminium comprend la sous-étape consistant à avoir la couche de phosphate d'aluminium ayant une épaisseur pour que l'électrode ait des propriétés électriques identiques avant et après la formation de la couche de phosphate d'aluminium.

7. Procédé selon la revendication 5, dans lequel la solution a une acidité de pH 3 à 5.

8. Procédé selon la revendication 5, comprenant en outre l'étape consistant à :
former une couche d'oxyde d'aluminium par-dessus l'électrode par anodisation.
